# EUROPÄISCHE PATENTSCHRIFT

(11) **EP 3 906 535 B1**
(45) Veröffentlichungstag und Bekanntmachung des Hinweises auf die Patenterteilung: **21.08.2024**
(21) Anmeldenummer: 20700334.4
(22) Anmeldetag: 03.01.2020
(51) Int. Cl.: G01P 15/08, G08B 29/18, H04Q 9/00

(54) **GERÄT ZUR ERFASSUNG DER AKTIVITÄT VON PERSONEN ODER DES ZUSTANDES VON DURCH PERSONEN BEEINFLUSSTEN INFRASTRUKTUREN ODER GEGENSTÄNDEN**
DEVICE FOR SENSING THE ACTIVITY OF PEOPLE OR THE STATUS OF INFRASTRUCTURES OR OBJECTS INFLUENCED BY PEOPLE
APPAREIL DE DÉTECTION DE L'ACTIVITÉ DE PERSONNES OU L'ÉTAT D'INFRASTRUCTURES OU D'OBJETS SOUS L'INFLUENCE DES PERSONNES

(30) Priorität: 04.01.2019 DE 102019100105
(43) Veröffentlichungstag der Anmeldung: 10.11.2021
(73) Patentinhaber: EnOcean GmbH, 82041 Oberhaching (DE)
(72) Erfinder: SCHMIDT, Frank, 81829 München (DE); SCZESNY, Oliver, 85609 Aschheim (DE)
(74) Vertreter: Epping - Hermann - Fischer
(86) Internationale Anmeldenummer: PCT/EP2020/050074
(87) Internationale Veröffentlichungsnummer: WO 2020/141214

(56) Entgegenhaltungen:
- EP-A1- 2 211 319
- WO-A1-03/034366
- GB-A- 2 367 173
- US-A1- 2005 046 580

## Beschreibung

Gerät zur Erfassung der Aktivität von Personen oder des Zustandes von durch Personen beeinflussten Infrastrukturen oder Gegenständen Die Erfindung betrifft ein Gerät zur Erfassung der Aktivität von Personen oder des Zustandes von durch Personen beeinflussten Infrastrukturen oder Gegenständen. Die Erfindung betrifft ferner ein Verfahren zur Erfassung der Aktivität von Personen oder des Zustandes von durch Personen beeinflussten Infrastrukturen oder Gegenständen. Solche Geräte sind zum Beispiel aus den Dokumenten GB-A-2367173 oder US-A1-2005/046580 bekannt.

Oftmals ist die Ermittlung der lokalen Anwesenheit von Personen oder Gegenständen (an Orten, in Räumen, an Arbeits- oder Sitzplätzen, usw.), sowie des Status der von Personen beeinflussten Infrastruktur, Geräten, Arbeits- oder Verbrauchsmaterialien usw. gewünscht.

Es gibt bereits verschiedene, insbesondere kabelgebundene, Sensoren, welche Anwesenheit und Aktivitäten von Personen in der Umgebung registrieren können. Beispiele sind Bewegungsmelder-Sensoren, wie sogenannte PIR-Sensoren (PIR = englisch: passive infrared), mit denen Personen durch Bewegung detektiert werden oder Kameras, welche durch Auswertung bewegter Bilder Informationen über Anzahl der Personen, deren Bewegungsprofil sowie über die beeinflusste Infrastruktur oder Geräte gewinnen. Andere Beispiele sind Sensoren, welche die Bewegung von Objekten, z.B. durch Erschütterung, erkennen, z.B. Glasbruchsensoren oder Türkontakte.

Die bisherigen Lösungen der beschriebenen Art haben diverse Nachteile. Die genannten Geräte oder Sensoren haben üblicherweise eine kabelgebundene Energieversorgung, was ihre Flexibilität einschränkt. PIR-Sensoren können zudem nur bewegte Wärmequellen (Personen) registrieren. Bei unbelebten Objekten funktionieren diese nicht, ebenso bei sich nur wenig bewegenden Personen. Kameras dürfen aus Datenschutzgründen oft nicht zur Aufzeichnung/Verarbeitung der Bilder von Personen benutzt werden.

Es ist Aufgabe der Erfindung ein Gerät sowie ein Verfahren der eingangs genannten Art zu beschreiben, die flexibel und vielseitig einsetzbar sind und die genannten Nachteile überwinden.

Diese Aufgabe wird gemäß einem ersten Aspekt durch ein Gerät nach den Patentansprüchen 1 und 5 gelöst.

Das Gerät ist zur Erfassung der Aktivität von Personen oder des Zustandes von durch Personen beeinflussten Infrastrukturen oder Gegenständen mittels Beschleunigungsmessung eingerichtet. Das Gerät weist mindestens einen Beschleunigungssensor zur Messung einer Beschleunigung auf. Der Beschleunigungssensor ist eingerichtet, auf einen voreingestellten Schwellwert einer gemessenen Beschleunigung zu reagieren. Der Beschleunigungssensor ist eingerichtet, bei Überschreitung des Schwellwertes zumindest eine der folgenden Aktionen auszulösen:
- Datenspeicherung,
- Modifikation eines Zählers oder
- Aussendung eines Datentelegramms per Funk.

Das Gerät weist einen Energiewandler auf zum Wandeln einer Primärenergie in elektrische Energie zum Betreiben des Geräts oder des Beschleunigungssensors. Der Energiewandler ist eingerichtet, die Primärenergie unabhängig von einer aus einer gemessenen Beschleunigung resultierenden Energie zu gewinnen.

Ein derartiges Gerät kann energieautark betrieben werden. Die für den Betrieb notwendige elektrische Energie kann über den Energiewandler aus einer Primärenergie gewonnen werden. Das Gerät ist dabei eingerichtet, die Primärenergie unabhängig von einer aus einer gemessenen Beschleunigung resultierenden Energie zu gewinnen.

Auf diese Weise ist das Gerät für dessen Betrieb über elektrische Energie unabhängig von einer Energie, die aus einer gemessenen Beschleunigung resultiert. Selbst wenn keine Beschleunigung erfasst wird, kann das Gerät über eine separate (Umwelt-)Primärenergie betrieben werden. Das Gerät erfordert insbesondere keine kabelgebundene Energieversorgung.

Über den Beschleunigungssensor, der zur Messung einer Beschleunigung eingerichtet ist, können in einer Vielzahl von Anwendungsfällen Aktivität, Anwesenheit, Betrieb, usw. von Personen, Geräten, Maschinen, etc. erfasst werden, welche durch Erschütterung, Vibration, Betätigung, etc. eine Beschleunigungskraft auslösen/erzeugen, die über den Beschleunigungssensor erfasst werden kann.

Das Gerät ist daher flexibel und vielseitig einsetzbar. Durch das Gerät kann die Ermittlung der lokalen Anwesenheit von Personen und deren Level der Aktivität sowie die Ermittlung des Status der von Personen beeinflussten Infrastruktur und von Geräten auf einfache Weise in vielerlei Anwendungsfällen erfolgen. Zum Beispiel kann die Anwesenheit von Personen an bestimmten Orten, in Räumen, an Sitzplätzen, Arbeitsplätzen, Liegeplätzen, Betten, in Fahrzeugen, etc. sowie gegebenenfalls deren Aktivität an diesen Orten detektiert werden. Ferner kann die Belegung/Belegungsrate von Sitzplätzen, Aufenthaltsorten, Arbeitsplätzen, Betten, Räumen, Sälen, oder auch Verbrauchszustände von Geräten, Maschinen, Material, Füllstände, Lagerhaltung, etc. erfasst bzw. erkannt werden. Dadurch ergibt sich eine Vielzahl von Anwendungsfällen im sanitären, klinischen, privaten, öffentlichen und industriellen Umfeld. Es ist auch möglich, den Ort einer Person oder eines Gegenstandes festzustellen sowie deren Lokalisierung/Ortung durchzuführen.

Bei allen diesen Einsatzszenarien erfolgt eine Erkennung einer Beschleunigung durch Erschütterung, Bewegung, Betätigung oder sonstige Beeinflussung der Person, die das Gerät trägt, des Gerätes selbst oder eines Apparates oder einer Maschine, die mit dem Gerät gekoppelt ist. Die Erfassung der Beschleunigung ermöglicht dann die sensorische bzw. geräteinterne oder auch externe Weiterverarbeitung dieser Informationen anhand der oben erläuterten ausgelösten Aktionen. Diese Aktionen können z.B. in einem oder gesteuert durch einen Mikrocontroller oder eine Mikrocontroller-Einheit durchgeführt werden. Hierzu kann das Gerät eine oder mehrere der Komponenten Mikrocontroller/Mikrocontroller-Einheit, (Daten-)Speicher (evtl. implementiert in Mikrocontroller/Mikrocontroller-Einheit), Zähler/Register (evtl. implementiert in Mikrocontroller/Mikrocontroller-Einheit) oder Funk-Sender aufweisen.

Bei dem Gerät der erläuterten Art können Schwellwerte/Grenzwerte einer Beschleunigung erkannt werden. Übersteigt eine gemessene Beschleunigung (oder deren Veränderung) einen oder mehrere voreingestellte Schwellwerte, werden bestimmte Aktionen der erläuterten Art oder sonstige Aktionen ausgelöst. Bleibt eine gemessene Beschleunigung (oder deren Veränderung) unter einem oder mehreren voreingestellten Schwellwerten, so wird entweder keine Aktionen unternommen oder andere Aktionen. Insofern ist das Gerät eingerichtet für eine Schwellwertmessung bzw. Schwellwerterfassung. Es muss insbesondere keine spektrale Analyse von Beschleunigungsverläufen durchgeführt werden, wie dies z.B. bei der Schwingungsanalyse an Maschinen oder Brücken der Fall ist. Das Gerät der erläuterten Art ermittelt lediglich die Überschreitung vorher festgelegter Grenzwerte oder ermittelt und überträgt periodisch aktuelle Beschleunigungswerte. Auf diese Weise ist das Gerät einfach implementierbar.

In diversen Implementierungen des Geräts ist der Beschleunigungssensor als einachsiger oder mehrachsiger, (integrierter) Beschleunigungssensor, insbesondere in MEMS-Bauweise, ausgeführt. Zum Beispiel erfolgt ein Anregen einer einachsigen oder mehrachsigen Mikromechanik des Beschleunigungssensors durch Beaufschlagen des Geräts bzw. des Beschleunigungssensors mit Kräften, z.B. Schwingungskräften, Vibration, etc. die in einer oder mehreren Raumrichtungen auf ein oder mehrere Masse- oder Schwing-Elemente der Mikromechanik des Beschleunigungssensors wirken und diese anregen.

In diversen Implementierungen des Geräts ist der Beschleunigungssensor zur Detektion der Beschleunigung gasförmiger Medien, insbesondere als Mikrofon, ausgeführt. Hierdurch ergeben sich Anwendungsmöglichkeiten zur Detektion von Luftschall oder Körperschall.

In diversen Implementierungen des Geräts weist das Gerät weiter eine oder mehrere der folgenden Komponenten auf:
- Mikrofon, insbesondere zur Aufnahme von Luftschall,
- Gassensor, insbesondere zur Messung von CO2 und/oder anderen Luftgasen,
- Temperatursensor,
- Feuchtesensor, insbesondere zur Messung der Feuchte der Umgebungsluft,
- Magnetkontakt, Hall-Sensor, insbesondere zur Erfassung der Annäherung von Magneten,
- Abstandssensor, insbesondere Ultraschallsensor, Lichtsensor oder induktiv arbeitender Sensor,
- Spannungssensor, insbesondere zur Messung des Energiezustands oder Energielevels der aus der Primärenergie gewandelten elektrischen Energie innerhalb des Gerätes,
- Helligkeitssensor,
- Taster zum manuellen Bedienen des Gerätes.

Durch die zusätzliche Implementierung einer oder mehrerer dieser Komponenten kann die Erkennung der Beschleunigung und Rückschlüsse darauf verbessert werden, wenn mehrere Sensoren/Komponenten eingesetzt werden, deren Daten kombiniert/fusioniert werden können.

Ferner kann auch der Betrieb des Gerätes an sich durch den Einsatz verschiedener Sensoren/Komponenten verbessert werden, die eine fusionierte Aussage über das zu steuernde Betriebsverhalten ermöglichen.

Die obige Aufgabe wird gemäß einem zweiten Aspekt durch ein Gerät nach einer oder mehreren der nachfolgend beschriebenen Implementierungen gelöst. Weitere Implementierungen sind in den Patentansprüchen offenbart.

Das Gerät ist zur Erfassung der Aktivität von Personen oder des Zustandes von durch Personen beeinflussten Infrastrukturen oder Gegenständen eingerichtet. Das Gerät weist mindestens zwei Sensoren auf. Die Sensoren sind zur Messung unterschiedlicher physikalischer Größen eingerichtet. Einer oder mehrere oder alle der Sensoren sind eingerichtet, auf einen voreingestellten Schwellwert der jeweils gemessenen physikalischen Größe zu reagieren und bei Überschreitung des Schwellwertes der gemessenen physikalischen Größe zumindest eine der folgenden Aktionen auszulösen:
- Datenspeicherung,
- Modifikation eines Zählers oder
- Aussendung eines Datentelegramms per Funk.

Das Gerät weist einen Energiewandler auf zum Wandeln einer Primärenergie in elektrische Energie zum Betreiben des Geräts oder eines oder mehrerer oder aller der Sensoren. Der Energiewandler ist eingerichtet, die Primärenergie unabhängig von einer aus der jeweils gemessenen physikalischen Größe resultierenden Energie zu gewinnen.

Die mindestens zwei Sensoren können jeweils ein Sensor der folgenden Art sein:
- Beschleunigungssensor, insbesondere der oben erläuterten Art,
- Mikrofon, insbesondere zur Aufnahme von Luftschall,
- Gassensor, insbesondere zur Messung von CO2 und/oder anderen Luftgasen,
- Temperatursensor,
- Feuchtesensor, insbesondere zur Messung der Feuchte der Umgebungsluft,
- Magnetkontakt, Hall-Sensor, insbesondere zur Erfassung der Annäherung von Magneten,
- Abstandssensor, insbesondere Ultraschallsensor, Lichtsensor oder induktiv arbeitender Sensor,
- Spannungssensor, insbesondere zur Messung des Energiezustands oder Energielevels der aus der Primärenergie gewandelten elektrischen Energie innerhalb des Gerätes,
- Helligkeitssensor.

Die Sensoren können aber auch auf andere Weise eingerichtet, implementiert oder konfiguriert sein.

In diversen Implementierungen des Geräts weist das Gerät einen Taster zum manuellen Bedienen des Gerätes auf.

Ein derartiges Gerät kann energieautark betrieben werden. Die für den Betrieb notwendige elektrische Energie kann über den Energiewandler aus einer Primärenergie gewonnen werden. Das Gerät ist dabei eingerichtet, die Primärenergie unabhängig von einer aus der jeweils gemessenen physikalischen Größe resultierenden Energie zu gewinnen. Auf diese Weise ist das Gerät für dessen Betrieb über elektrische Energie unabhängig von einer Energie, die aus einer gemessenen physikalischen Größe resultiert. Selbst wenn kein signifikanter Wert einer gemessenen physikalischen Größe erfasst wird, kann das Gerät über eine separate (Umwelt-)Primärenergie betrieben werden. Das Gerät erfordert insbesondere keine kabelgebundene Energieversorgung.

Über die mindestens zwei Sensoren, die zur Messung unterschiedlicher physikalischer Größen eingerichtet sind, können in einer Vielzahl von Anwendungsfällen Aktivität, Anwesenheit, Betrieb, usw. von Personen, Geräten, Maschinen, etc. erfasst werden, welche durch Veränderung der gemessenen physikalischen Größen (z.B. Beschleunigung, Temperatur, (Luft-)Feuchtigkeit, Schall, Gas, magnetische Effekte, Distanz, Licht/Beleuchtung) detektierbar sind. Durch Heranziehen von mehreren Sensoren kann die Erkennung auch verbessert werden, weil mehrere Arten der Sensierung kombiniert/fusioniert werden können.

Ferner kann auch der Betrieb des Gerätes an sich durch den Einsatz verschiedener Sensoren verbessert werden, die eine fusionierte Aussage über das zu steuernde Betriebsverhalten ermöglichen.

Das Gerät ist daher flexibel und vielseitig einsetzbar. Durch das Gerät kann die Ermittlung der lokalen Anwesenheit von Personen und deren Level der Aktivität sowie die Ermittlung des Status der von Personen beeinflussten Infrastruktur und von Geräten auf einfache Weise in vielerlei Anwendungsfällen erfolgen. Zum Beispiel kann die Anwesenheit von Personen an bestimmten Orten, in Räumen, an Sitzplätzen, Arbeitsplätzen, Liegeplätzen, Betten, in Fahrzeugen, etc. sowie gegebenenfalls deren Aktivität an diesen Orten detektiert werden. Ferner kann die Belegung/Belegungsrate von Sitzplätzen, Aufenthaltsorten, Arbeitsplätzen, Betten, Räumen, Sälen, oder auch Verbrauchszustände von Geräten, Maschinen, Material, Füllstände, Lagerhaltung, etc. erfasst bzw. erkannt werden. Dadurch ergibt sich eine Vielzahl von Anwendungsfällen im sanitären, klinischen, privaten, öffentlichen und industriellen Umfeld. Es ist auch möglich, den Ort einer Person oder eines Gegenstandes festzustellen sowie deren Lokalisierung/Ortung durchzuführen.

Bei allen diesen Einsatzszenarien erfolgt eine Erkennung einer Veränderung unterschiedlicher physikalischer Größen durch wenigstens zwei Sensoren oder einer sonstige Beeinflussung der physikalischen Größen durch die Person, die das Gerät trägt, das Gerät selbst oder einen Apparat oder eine Maschine, die mit dem Gerät gekoppelt ist. Die Erfassung der Veränderung der unterschiedlichen physikalischen Größen ermöglicht dann die sensorische bzw. geräteinterne oder auch externe Weiterverarbeitung dieser Informationen anhand der oben erläuterten ausgelösten Aktionen.

Bei dem Gerät der erläuterten Art können jeweilige Schwellwerte/Grenzwerte der unterschiedlichen physikalischen Größen bzw. deren Veränderung erkannt werden. Übersteigt eine gemessene physikalische Größe bzw. deren Veränderung einen oder mehrere voreingestellte Schwellwerte, werden bestimmte Aktionen der erläuterten Art oder sonstige Aktionen ausgelöst. Bleibt eine gemessene physikalische Größe bzw. deren Veränderung unter einem oder mehreren voreingestellten Schwellwerten, so wird entweder keine Aktionen unternommen oder andere Aktionen. Insofern ist das Gerät eingerichtet für eine Schwellwertmessung bzw. Schwellwerterfassung. Es muss insbesondere keine spektrale Analyse von physikalischen Größen bzw. deren Veränderung durchgeführt werden. Das Gerät der erläuterten Art ermittelt lediglich die Überschreitung vorher festgelegter Grenzwerte oder ermittelt und überträgt periodisch aktuelle Werte der gemessenen physikalischen Größen bzw. deren Veränderung. Auf diese Weise ist das Gerät einfach implementierbar. Die nachstehend erläuterten weitergehenden Implementierungen können sowohl bei einem Gerät gemäß dem obigen ersten Aspekt als auch bei einem Gerät gemäß dem obigen zweiten Aspekt realisiert werden.

In diversen Implementierungen des Geräts umfasst der Energiewandler eine Solarzelle, wobei die Primärenergie Lichtenergie ist. Dies stellt eine einfache Art dar, elektrische Energie aus Umgebungsenergie, nämlich Lichtenergie, zu gewinnen.

In diversen Implementierungen des Geräts umfasst der Energiewandler einen elektromechanischen Wandler, einen thermischen Wandler oder einen magnetischen Wandler oder eine Kombination davon. Optional kann der Energiewandler auch in diesen Implementierungen eine Solarzelle aufweisen. Dies stellt weitere Möglichkeiten dar, aus verschiedenen Umwelt- bzw. Umgebungsenergien elektrische Energie zu gewinnen.

Erfindungsgemäss weist das Gerät weiter eine Energiespeicher-Einrichtung auf. Die Energiespeicher-Einrichtung ist eingerichtet, die über den Energiewandler aus der Primärenergie gewandelte elektrische Energie zu speichern. Auf diese Weise ist das Gerät auch betreibbar, wenn (kurz- oder mittelfristig) keine Primärenergiequelle zur Verfügung steht, z.B. bei Lichtenergie nachts.

In diversen Implementierungen des Geräts weist das Gerät weiter eine Lademanagement-Einrichtung zum Lademanagement der Energiespeicher-Einrichtung auf. Die Lademanagement-Einrichtung ist eingerichtet, eine Begrenzung der Ladespannung auf einen Maximalwert zu steuern und unterhalb einer vorgegebenen Mindestspannung der Energiespeicher-Einrichtung einen Energieverbrauch des Gerätes zu steuern, einzuschränken oder abzustellen. Dies hat den Vorteil, dass das Gerät, insbesondere die Energiespeicher-Einrichtung, vor Überspannung und/oder Tiefentladung geschützt ist.

In erfindungsgemässen Implementierungen des Geräts umfasst die Energiespeicher-Einrichtung einen ersten Energiespeicher und einen zweiten Energiespeicher. Der erste Energiespeicher hat eine höhere Speicherkapazität als der zweite Energiespeicher. Der zweite Energiespeicher hat einen niedrigeren Innenwiderstand als der erste Energiespeicher. Der erste Energiespeicher und der zweite Energiespeicher sind eingerichtet, die über den Energiewandler aus der Primärenergie gewandelte elektrische Energie zu speichern. Durch eine derartige Kombination zweier Energiespeicher ist es möglich, konträre Anforderungen an lange Laufzeiten ohne (periodische) Umgebungsenergie/Primärenergie (z.B. mehrere Tage ohne Licht in Gebäuden) und an eine sofortige Betriebsbereitschaft, sobald Umgebungsenergie/Primärenergie zur Verfügung steht, zu erfüllen.

In diversen Implementierungen des Geräts sind der erste Energiespeicher und der zweite Energiespeicher derart über eine oder mehrere Dioden verschaltet, dass elektrische Energie vom ersten Energiespeicher in den zweiten Energiespeicher übertragen werden kann, jedoch nicht vom zweiten Energiespeicher in den ersten Energiespeicher. Dadurch wird verhindert, dass der zweite Energiespeicher (mit kleinerer Speicherkapazität) seine Energie in Richtung des ersten (großen) Energiespeichers entlädt. Der zweite Energiespeicher kann jedoch relativ schnell aus der Primärenergie mit elektrischer Energie geladen werden und realisiert daher eine sehr schnelle bzw. sofortige Betriebsbereitschaft. Wird der zweite Energiespeicher aufgrund des Betriebes des Gerätes entladen, kann er jedoch aus dem ersten Energiespeicher (vorausgesetzt, dieser hat einen ausreichenden Energielevel erreicht) (nach-)geladen werden. Der erste Energiespeicher realisiert daher eine lange Laufzeit ohne (periodische) Umgebungsenergie/Primärenergie.

In diversen Implementierungen des Geräts ist der zweite Energiespeicher derart verschaltet, dass elektrische Energie zum Betreiben des Geräts oder von einzelnen Komponenten des Gerätes aus dem zweiten Energiespeicher entnehmbar ist und der zweite Energiespeicher durch elektrische Energie aus dem ersten Energiespeicher nachladbar ist. In diesen Implementierungen ist der zweite Energiespeicher der primäre Energiespeicher aus dem elektrische Energie für den Betrieb des Gerätes oder einzelner Komponenten bezogen wird. Der zweite Energiespeicher kann über den ersten Energiespeicher nachgeladen werden.

In diversen Implementierungen des Geräts weist das Gerät weiter eine Energiespeicher-Hilfseinrichtung auf. Die Energiespeicher-Hilfseinrichtung ist separat zur Energiespeicher-Einrichtung eingerichtet zum Bereitstellen einer elektrischen Hilfsenergie zum Betreiben des Gerätes oder einzelner Komponenten des Gerätes. Die Energiespeicher-Hilfseinrichtung ermöglicht einen Betrieb des Gerätes oder einzelner Komponenten des Gerätes, wenn (mittel- oder langfristig) keine Primärenergie zur Verfügung steht und der erste Energiespeicher oder der zweite Energiespeicher keine ausreichende elektrische Energie mehr bereitstellen können. Die Energiespeicher-Hilfseinrichtung kann z.B. eine Batterie (z.B. alkalische Batterie oder Lithium-Batterie) sein.

In diversen Implementierungen des Geräts weist das Gerät weiter einen Mikrokontroller auf. In diversen Implementierungen des Geräts weist das Gerät weiter einen Daten-Speicher auf. Der Daten-Speicher kann innerhalb des Mikrocontrollers eingerichtet sein. In diversen Implementierungen des Geräts weist das Gerät weiter ein Software-Programm zum Steuern des Mikrocontrollers auf. Das Software-Programm kann innerhalb des Daten-Speichers gespeichert sein. In diversen Implementierungen des Geräts weist das Gerät weiter einen Funk-Transmitter (Sender) auf.

Der Mikrokontroller und/oder das Software-Programm können derart implementiert sein, dass eine Steuerung von Abläufen innerhalb des Gerätes auf ein Trigger-Signal hin erfolgt. Alternativ oder ergänzend können der Mikrokontroller und/oder das Software-Programm derart implementiert sein, dass eine Steuerung periodischer Abläufe erfolgt, die wiederholt nach voreingestellten oder zufällig gewählten Zeitspannen gestartet werden können.

In diversen Implementierungen des Geräts weist das Gerät weiter eine Drahtlos-Schnittstelle, insbesondere eine Nahfeld-Kommunikations-Schnittstelle, zur drahtlosen Kommunikation und/oder Datenaustausch und/oder Energieübertragung mit anderen Geräten auf.

Die obige Aufgabe wird gemäß einem dritten Aspekt durch ein Verfahren nach Anspruch 14 gelöst.

Das Verfahren ist zur Erfassung der Aktivität von Personen oder des Zustandes von durch Personen beeinflussten Infrastrukturen oder Gegenständen mittels Beschleunigungsmessung implementiert. Es erfolgt ein Messen einer Beschleunigung durch einen Beschleunigungssensor. Der Beschleunigungssensor ist z.B. in einem Gerät implementiert. Es erfolgt ein Reagieren des

Beschleunigungssensors auf einen voreingestellten Schwellwert der gemessenen Beschleunigung. Es erfolgt ein Auslösen zumindest einer der folgenden Aktionen durch den Beschleunigungssensor bei Überschreitung des Schwellwertes:
- Datenspeicherung,
- Modifikation eines Zählers oder
- Aussendung eines Datentelegramms per Funk.

Bei dem Verfahren wird der Beschleunigungssensor über eine aus einer Primärenergie gewonnene elektrische Energie betrieben. Die Primärenergie wird unabhängig von einer aus der gemessenen Beschleunigung resultierenden Energie gewonnen.

Dieses Verfahren ermöglicht ebenso die Vorteile, wie sie im Zusammenhang mit einem Gerät gemäß dem ersten oder zweiten Aspekt oben erläutert worden sind.

In diversen Implementierungen des Verfahrens, bei denen der Beschleunigungssensor in einem Gerät implementiert ist, weist das Gerät den Energiewandler auf, der eine Primärenergie in elektrische Energie zum Betreiben des Geräts oder des Beschleunigungssensors wandelt. Der Beschleunigungssensor wird über die aus der Primärenergie gewonnene elektrische Energie betrieben. Der Energiewandler gewinnt die Primärenergie unabhängig von einer aus der gemessenen Beschleunigung resultierenden Energie.

Erfindungsgemäss weist das Gerät eine Energiespeicher-Einrichtung auf, die die über den Energiewandler aus der Primärenergie gewandelte elektrische Energie speichert. Die Energiespeicher-Einrichtung umfasst einen ersten Energiespeicher und einen zweiten Energiespeicher. Der erste Energiespeicher hat eine höhere Speicherkapazität als der zweite Energiespeicher. Der zweite Energiespeicher hat einen niedrigeren Innenwiderstand als der erste Energiespeicher. Der erste Energiespeicher und der zweite Energiespeicher speichern die über den Energiewandler aus der Primärenergie gewandelte elektrische Energie.

Die obige Aufgabe wird gemäß einem vierten Aspekt durch ein Verfahren nach Anspruch 15 gelöst.

Das Verfahren ist zur Erfassung der Aktivität von Personen oder des Zustandes von durch Personen beeinflussten Infrastrukturen oder Gegenständen mittels Auswertung von mindestens zwei unterschiedlichen physikalischen Größen implementiert. Es erfolgt ein Messen von wenigstens zwei unterschiedlichen physikalischen Größen durch mindestens zwei verschiedene Sensoren. Die Sensoren sind z.B. in einem Gerät implementiert. Es erfolgt ein Reagieren eines oder mehrerer oder aller der mindestens zwei Sensoren auf einen voreingestellten Schwellwert der jeweils gemessenen physikalischen Größe. Es erfolgt ein Auslösen zumindest einer der folgenden Aktionen durch mindestens einen reagierenden Sensor bei Überschreitung des Schwellwertes:
- Datenspeicherung,
- Modifikation eines Zählers oder
- Aussendung eines Datentelegramms per Funk.

Bei dem Verfahren werden einer oder mehrere oder alle der mindestens zwei Sensoren über eine aus einer Primärenergie gewonnene elektrische Energie betrieben. Die Primärenergie wird unabhängig von einer aus den jeweils gemessenen physikalischen Größen resultierenden Energie gewonnen.

Dieses Verfahren ermöglicht ebenso die Vorteile, wie sie im Zusammenhang mit einem Gerät gemäß dem ersten oder zweiten Aspekt oben erläutert worden sind.

In diversen Implementierungen des Verfahrens, bei denen die Sensoren in einem Gerät implementiert sind, weist das Gerät den Energiewandler auf, der eine Primärenergie in elektrische Energie zum Betreiben des Geräts oder der Sensoren wandelt. Die Sensoren werden über die aus der Primärenergie gewonnene elektrische Energie betrieben. Der Energiewandler gewinnt die Primärenergie unabhängig von einer aus den jeweils gemessenen physikalischen Größen resultierenden Energie.

Erfindungsgemäss weist das Gerät eine Energiespeicher-Einrichtung auf, die die über den Energiewandler aus der Primärenergie gewandelte elektrische Energie speichert. Die Energiespeicher-Einrichtung umfasst einen ersten Energiespeicher und einen zweiten Energiespeicher. Der erste Energiespeicher hat eine höhere Speicherkapazität als der zweite Energiespeicher. Der zweite Energiespeicher hat einen niedrigeren Innenwiderstand als der erste Energiespeicher. Der erste Energiespeicher und der zweite Energiespeicher speichern die über den Energiewandler aus der Primärenergie gewandelte elektrische Energie.

Die Erfindung wird nachfolgend anhand einer Ausführungsform unter Zuhilfenahme einer Zeichnung näher erläutert.

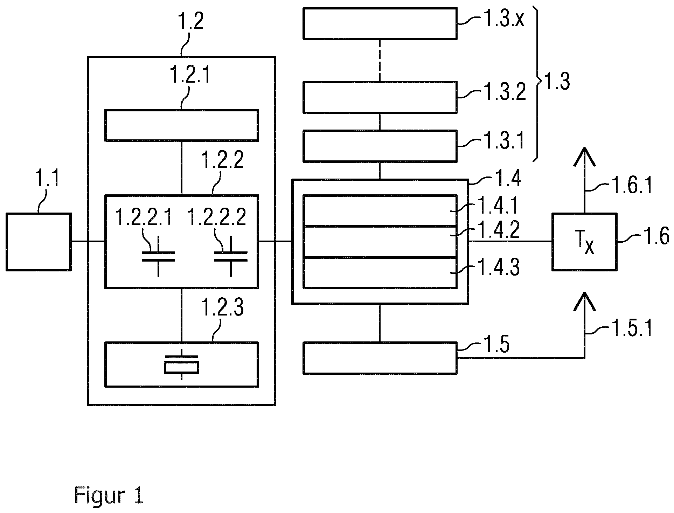

Figur 1 zeigt in einem Blockschaltbild schematisiert eine Ausführungsform eines Gerätes zur Erfassung der Aktivität von Personen oder des Zustandes von durch Personen beeinflussten Infrastrukturen oder Gegenständen.

Ein zentrales Element ist ein Beschleunigungssensor (Sensor 1.3.1). Der Beschleunigungssensor 1.3.1 ist vorzugsweise ein mehrachsiger, integrierter Beschleunigungssensor in MEMS-Bauweise. Andere Beschleunigungssensoren, die auf die Beschleunigung von Festkörpern reagieren, können ebenfalls zum Einsatz kommen, wie mechanische Beschleunigungs-Schwellwertschalter oder piezoelektrische Beschleunigungssensoren.

Weitere Sensoren 1.3.2 bis 1.3.x können ebenfalls optional implementiert sein. Die Sensoren (Sensorgruppe) 1.3 sind allgemein eingerichtet (unterschiedliche) physikalische Größen zu detektieren. Näheres wird weiter unten erläutert.

Weitere Komponenten in der Ausführungsform gemäß Figur 1 sind eine Mikrokontroller-Einheit 1.4. Diese umfasst einen Mikrokontroller 1.4.2 mit Speichermöglichkeit/Speicher 1.4.3 (für Daten, Informationen, Code, usw.) sowie ein Software-Programm 1.4.1 des Mikrocontrollers (zu dessen Steuerung). Ferner ist ein Radio-Transmitter (Funk-Sender/Funk-Transmitter) 1.6 mit Antenne 1.6.1 sowie eine Energieversorgungseinheit 1.2 sowie eine Energiequelle bzw. Energiewandler 1.1 für eine Primärenergie eingerichtet.

Die Energiequelle bzw. der Energiewandler 1.1 umfasst in der Ausführungsform gemäß Figur 1 z.B. eine Solarzelle, welche Umgebungslicht (als Primärenergie) in eine elektrische Spannung (elektrische Energie) umwandelt. Weiterhin umfasst die Energieversorgungseinheit 1.2 eine Energie-Managementschaltung (Lademanagement-Einrichtung) 1.2.1, welche die Aufladung eines oder mehrerer elektrischer Energiespeicher 1.2.2.1 und 1.2.2.2 einer Energiespeicher-Einrichtung 1.2.2 steuert. Die Energie-Managementschaltung 1.2.1 stellt wenigstens die Funktionen eines Überspannungsschutzes und/oder eines Tiefentladungsschutzes der Energiespeicher-Einrichtung 1.2.2 bereit.

Die Speicherung der elektrischen Energie aus der Energiequelle bzw. dem Energiewandler 1.1 findet in den zwei getrennten Energiespeichern 1.2.2.1 und 1.2.2.2 statt. Dies ermöglicht einen Ausgleich von Vor- und Nachteilen von verlustarmen Energiespeichern und einen energieautarken Betrieb des Gerätes.

Der Energiespeicher 1.2.2.1 hat ein hohes Speichervolumen (hohe Speicherkapazität), jedoch auch einen hohen Innenwiderstand von typisch > 10 Ohm. Dieser Energiespeicher 1.2.2.1 kann die benötigte Energie für einen z.B. mehrwöchigen Betrieb speichern. Allerdings ist er wegen seines Prinzip-bedingt hohen elektrischen Innenwiderstandes eher ungeeignet für hohe Stromspitzen, wie sie z.B. beim Sendebetrieb des Funksenders 1.6 auftreten. Typische Vertreter dieser Energiespeicher 1.2.2.1 sind sogenannte Doppelschicht-Kondensatoren, Superkondensatoren (PAS-Kondensatoren) mit Kapazitäten zwischen 0,05 Farad und 100 Farad, oder auch wiederaufladbare elektrochemische Speicher mit Speicher-Kapazitäten zwischen 1 mAh und 5000 mAh.

Der Energiespeicher 1.2.2.2 hat ein wesentlich kleineres Speichervolumen (kleine Speicherkapazität) und kann Energie nur für z.B. wenige Aktionen oder gar nur eine Aktion, z.B. "Beschleunigung messen + Funktelegramm aussenden", speichern. Allerdings kann der Energiespeicher 1.2.2.2 kurzzeitig hohe elektrische Ströme liefern, da er Prinzip-bedingt einen niedrigen Innenwiderstand von typisch < 1 Ohm aufweist. Typische Vertreter dieser Energiespeicher 1.2.2.2 sind z.B. Elektrolytkondensatoren oder Tantal-Kondensatoren mit Kapazitätswerten zwischen 50µE und 5000µF.

Die beiden Energiespeicher 1.2.2.1 und 1.2.2.2 werden über Dioden (nicht dargestellt) so verschaltet, dass zunächst immer der niederohmige Energiespeicher 1.2.2.2 geladen wird. Erst, wenn seine Maximalspannung erreicht wurde, wird Energiespeicher 1.2.2.1 weiter aufgeladen, bis auch dieser seine Maximalspannung erreicht. Die Entscheidung, wann die Aufladung der Energiespeicher 1.2.2.2 und 1.2.2.1 umgeschaltet wird, trifft ein elektronisch realisierter Schwellwertschalter. Erst dann wird die Aufladung unterbrochen. In der Ausführungsform gemäß Figur 1 greifen alle Funktionen/Komponenten des Gerätes auf den Energiespeicher 1.2.2.2 zu. Da Aktionen mit hohem Strombedarf sehr kurz sind (typisch zwischen 0,3 und 50 Millisekunden) und relativ selten stattfinden (typisch 1 Mal pro Tag bis 1 Mal alle 10 Sekunden), kann der Energiespeicher 1.2.2.2 in den Pausen zwischen hohen Stromabrufen gut/ausreichend durch den Energiespeicher 1.2.2.1 nachgeladen werden.

Durch die derartige Kombination dieser beiden Energiespeicher 1.2.2.1 und 1.2.2.2 wird es möglich, die konträren Anforderungen nach langen Laufzeiten ohne periodische Umgebungsenergie (z.B. Langes Wochenende ohne Licht in Gebäuden) und nach sofortiger Betriebsbereitschaft, sobald Licht auf die Solarzelle 1.1 fällt (der Energiespeicher 1.2.2.2 ist sehr schnell aufgeladen) beide zu erfüllen.

Optional kann in der Ausführungsform gemäß Figur 1 ein weiterer Energiespeicher (Energiespeicher-Hilfseinrichtung) 1.2.3 eingesetzt werden, welcher z.B. als Batterie ausgeführt ist. Dieser Energiespeicher 1.2.3 tritt nur dann in Funktion, wenn zum Beispiel in seltenen langen Zeiten ohne Licht, die Energiespeicher 1.2.2.1 und auch 1.2.2.2 unter einen bestimmten Energiegehalt fallen. Der Energiespeicher 1.2.3 kann dann zur Nachladung der Energiespeicher 1.2.2.1 und 1.2.2.2 verwendet werden. Alternativ kann dem Energiespeicher 1.2.3 unmittelbar (d.h. ohne Umweg eines Nachladens der Energiespeicher 1.2.2.1 und 1.2.2.2) elektrische Energie zum weiteren Betrieb des Gerätes oder einzelner Komponenten entnommen werden.

Typische Vertreter des Energiespeichers 1.2.3 sind alkalische Batterien oder Lithium-Batterien, die in der Regel nicht wiederaufladbar sind, jedoch ihre Ladung über viele Jahre - typisch 10 Jahre und mehr - speichern können.

Der Beschleunigungssensor 1.3.1 (oder auch andere Sensoren aus der Gruppe der Sensoren 1.3) wird in der Ausführungsform gemäß Figur 1 von der Mikrokontroller-Einheit 1.4 gesteuert. Es sind verschiedene alternative oder ergänzende Betriebsmodi möglich.

### Beispiele:

a) Betriebsmodus. Der Beschleunigungssensor 1.3.1 ist aktiv und wartet in einem "low power"-Modus darauf, dass zumindest eine vorher festgelegte Beschleunigungsschwelle (Schwellwert der Beschleunigung) überschritten wird. In diesem Zustand sind alle oder einige der Schaltungsblöcke/Funktionsblöcke/Komponenten, die gerade nicht benötigt werden, abgeschaltet. Sobald die Beschleunigung den festgesetzten Schwellwert erreicht oder überschreitet, werden weitere Schaltungsblöcke/Funktionsblöcke/Komponenten aktiviert - zumindest jedoch der Mikrokontroller 1.4, der je nach hinterlegtem Software-Programm 1.4.1 Aktionen steuert, bevor das System wieder in den Ausgangsmodus zurückkehrt. Diese Aktionen können alle oder Teile der folgenden Elemente beinhalten: das Speichern des Beschleunigungs-Ereignisses, das Hochsetzen eines Zählers, das Aussenden des Ereignisses und/oder des Zählerstandes per Funk (z.B. über den Funk-Sender 1.6).
b) Weiterhin kann das Aussenden von Ergebnissen oder Lebenszeichen periodisch nach einen vereinbarten Schema erfolgen, unabhängig oder abhängig von den gemessenen Beschleunigungswerten.
c) Es wird keine spektrale Analyse von Beschleunigungsverläufen durchgeführt, wie dies z.B. bei der Schwingungsanalyse an Maschinen oder Brücken der Fall ist. Das Verfahren ermittelt lediglich die Überschreitung vorher festgelegter Grenzwerte/Schwellwerte oder ermittelt und überträgt periodisch aktuelle Beschleunigungswerte.
d) Flugmodus. Da das Gerät sich aus Umgebungsenergie speist und in der Regel keinen separaten Ausschalter besitzt, muss beim Transport sichergestellt werden, dass keine Funktelegramme abgesendet werden. Hierzu weist der Sensor in der Ausführungsform gemäß Figur 1 einen Taster oder eine andere Eingabe-Schnittstelle (nicht dargestellt) auf, mit dem verschiedene Betriebsmodi durch eine vordefinierte Tastenfolge umschaltbar sind. Dazu zählt insbesondere auch ein Flugmodus, in dem keine Funktelegramme versendet werden.

Optional werden neben dem Beschleunigungssensor 1.3.1 weitere Sensoren, in Figur 1 durch 1.3.2 bis 1.3.x angedeutet, verwendet, um möglichst sinnvoll viele Informationen aus dem Umfeld des Gerätes zu bekommen.

Beispiele für sinnvolle weitere Sensoren sind:
- Mikrofone zur Aufnahme von Luftschall
- Gassensoren (CO2 und andere Luftgase)
- Temperatursensoren
- Feuchtesensoren (Feuchte der Umgebungsluft)
- Magnetkontakte, Hall-Sensoren (Annäherung von Magneten)
- Abstandssensoren (Ultraschall, Licht oder induktiv)
- Spannungssensoren (eigener Energiezustand der Speicher)
- Helligkeitssensor
- Taster zum manuellen Bedienen.

Alle genannten Sensoren (Liste nicht vollständig) können die Information der Beschleunigung sinnvoll ergänzen und so ein vollständigeres Bild über Aktivitäten im Sensorumfeld geben. Weiterhin kann durch die Auswertung mehrerer Sensoren zum jeweiligen Zeitpunkt eine wirksame Verbesserung der Fehlalarmrate erfolgen. Eine andere Anwendung zusätzlicher Sensorinformation ist die Reduzierung des eigenen Energiebedarfs.

Beispiele:
a) Ein Lichtsensor (z.B. Sensor 1.3.2) unterscheidet zwischen Tag und Nacht. Nachts sind ggf. keine periodischen Funktelegramme erforderlich - die Energie kann gespart werden, indem nur ab einer voreingestellten Mindesthelligkeit gesendet wird.
b) Der Energiezustand der Energiespeicher 1.2.2 und/oder 1.2.3 wird periodisch gemessen (über einen oder mehrere Spannungssensoren in der Sensorgruppe 1.3). Sollte der Energiezustand aufgrund schlechter Verfügbarkeit von Umgebungsenergie unter eine vordefinierte Schwelle fallen, könnte das Gerät in einen stromsparenden Betriebsmodus wechseln, in dem z.B. die periodischen Arbeitszyklen seltener ausgeführt werden (jedoch auf Kosten der Echtzeit-Fähigkeit). Auf diese Weise kann die Funktion jedoch aufrechterhalten werden, bis wieder mehr Energie zur Verfügung steht.
c) Vibrationen, z.B. auf einem Tisch, können als Maß für (menschliche) Aktivität in der Umgebung dienen. Durch Einbeziehen von Luftschall-Messungen (z.B. über ein Mikrofon in der Sensorgruppe 1.3) oder Gasmessungen (z.B. CO2-Gehalt der Luft, gemessen über einen Gassensor in der Sensorgruppe 1.3) lässt sich die Zuverlässigkeit und Genauigkeit der Aussagen jedoch wesentlich steigern. Fehlerquellen z.B. durch vorbeifahrende Lastwagen oder Züge oder am Tisch vorbeilaufende Menschen, können potentiell eliminiert werden.

Optional weist das Gerät neben dem Funk-Sender 1.6 eine weitere drahtlose Schnittstelle 1.5 auf, die sich insbesondere der sogenannten "NFC"-Technologie (Near Field Communication) bedienen kann. Kennzeichen dieser Technologie ist, dass sowohl Daten als auch Betriebsenergie über kurze Entfernungen (einige cm) übertragen werden können. Die Übertragung von Energie ist, insbesondere bei Geräten, die mit Umgebungsenergie betrieben werden können, wichtig. Denn der Energiespeicher 1.2.2 oder 1.2.3 kann leer sein. Dennoch möchte man gerne
- kommunizieren,
- Daten auslesen,
- die Software updaten.

Dies soll, vollständig oder teilweise, durch die optionale Schnittstelle 1.5 realisiert werden. Die Schnittstelle weist hierzu eine Antenne 1.5.1 auf.

Die dargestellte Ausführungsform ist lediglich beispielhaft gewählt.

### Bezugszeichenliste

- 1.1: Energiewandler/Energiequelle
- 1.2: Energieversorgungseinheit
- 1.2.1: Energie-Managementschaltung/Lademanagement-Einrichtung
- 1.2.2: Energiespeicher-Einrichtung
- 1.2.2.1: Energiespeicher
- 1.2.2.2: Energiespeicher
- 1.2.3: Energiespeicher/Energiespeicher-Hilfseinrichtung
- 1.3: Sensorgruppe
- 1.3.1: Beschleunigungssensor
- 1.3.2: weiterer Sensor
- 1.3.x: weiterer Sensor
- 1.4: Mikrokontroller-Einheit
- 1.4.1: Software-Programm
- 1.4.2: Mikrokontroller
- 1.4.3: (Daten-)Speicher
- 1.5: drahtlose Schnittstelle
- 1.5.1: Antenne
- 1.6: Funk-Sender/Funk-Transmitter
- 1.6.1: Antenne

## Patentansprüche

1. Gerät zur Erfassung der Aktivität von Personen oder des Zustandes von durch Personen beeinflussten Infrastrukturen oder Gegenständen mittels Beschleunigungsmessung,
- wobei das Gerät mindestens einen Beschleunigungssensor (1.3.1) zur Messung einer Beschleunigung aufweist,
- wobei der Beschleunigungssensor (1.3.1) eingerichtet ist, auf einen voreingestellten Schwellwert einer gemessenen Beschleunigung zu reagieren und bei Überschreitung des Schwellwertes zumindest eine der folgenden Aktionen auszulösen:
- Datenspeicherung,
- Modifikation eines Zählers oder
- Aussendung eines Datentelegramms per Funk, und
- wobei das Gerät einen Energiewandler (1.1) aufweist zum Wandeln einer Primärenergie in elektrische Energie zum Betreiben des Geräts oder des Beschleunigungssensors (1.3.1), wobei der Energiewandler (1.1) eingerichtet ist, die Primärenergie unabhängig von einer aus einer gemessenen Beschleunigung resultierenden Energie zu gewinnen,
- wobei das Gerät eine Energiespeicher-Einrichtung (1.2.2) aufweist, die eingerichtet ist, die über den Energiewandler (1.1) aus der Primärenergie gewandelte elektrische Energie zu speichern, wobei die Energiespeicher-Einrichtung (1.2.2) einen ersten Energiespeicher (1.2.2.1) und einen zweiten Energiespeicher (1.2.2.2) umfasst, wobei der erste Energiespeicher (1.2.2.1) eine höhere Speicherkapazität hat als der zweite Energiespeicher (1.2.2.2) und wobei der zweite Energiespeicher (1.2.2.2) einen niedrigeren Innenwiderstand hat als der erste Energiespeicher (1.2.2.1), und wobei der erste Energiespeicher (1.2.2.1) und der zweite Energiespeicher (1.2.2.2) eingerichtet sind, die über den Energiewandler (1.1) aus der Primärenergie gewandelte elektrische Energie zu speichern.

2. Gerät nach Anspruch 1, wobei der Beschleunigungssensor (1.3.1) als einachsiger oder mehrachsiger Beschleunigungssensor, insbesondere in MEMS-Bauweise, ausgeführt ist.

3. Gerät nach Anspruch 1 oder 2, wobei der Beschleunigungssensor (1.3.1) zur Detektion der Beschleunigung gasförmiger Medien, insbesondere als Mikrofon, ausgeführt ist.

4. Gerät nach einem der Ansprüche 1 bis 3, weiter aufweisend eine oder mehrere der folgenden Komponenten:
- Mikrofon, insbesondere zur Aufnahme von Luftschall,
- Gassensor, insbesondere zur Messung von CO2 und/oder anderen Luftgasen,
- Temperatursensor,
- Feuchtesensor, insbesondere zur Messung der Feuchte der Umgebungsluft,
- Magnetkontakt, Hall-Sensor, insbesondere zur Erfassung der Annäherung von Magneten,
- Abstandssensor, insbesondere Ultraschallsensor, Lichtsensor oder induktiv arbeitender Sensor,
- Spannungssensor, insbesondere zur Messung des Energiezustands oder Energielevels der aus der Primärenergie gewandelten elektrischen Energie innerhalb des Gerätes,
- Helligkeitssensor,
- Taster zum manuellen Bedienen des Gerätes.

5. Gerät zur Erfassung der Aktivität von Personen oder des Zustandes von durch Personen beeinflussten Infrastrukturen oder Gegenständen,
- wobei das Gerät mindestens zwei Sensoren (1.3.1, 1.3.2, 1.3.x) aufweist, die zur Messung unterschiedlicher physikalischer Größen eingerichtet sind,
- wobei einer oder mehrere oder alle der Sensoren (1.3.1, 1.3.2, 1.3.x) eingerichtet sind, auf einen voreingestellten Schwellwert der jeweils gemessenen physikalischen Größe zu reagieren und bei Überschreitung des Schwellwertes der gemessenen physikalischen Größe zumindest eine der folgenden Aktionen auszulösen:
- Datenspeicherung,
- Modifikation eines Zählers oder
- Aussendung eines Datentelegramms per Funk, und
- wobei das Gerät einen Energiewandler (1.1) aufweist zum Wandeln einer Primärenergie in elektrische Energie zum Betreiben des Geräts oder eines oder mehrerer oder aller der Sensoren (1.3.1, 1.3.2, 1.3.x), wobei der Energiewandler (1.1) eingerichtet ist, die Primärenergie unabhängig von einer aus der jeweils gemessenen physikalischen Größe resultierenden Energie zu gewinnen,
- wobei das Gerät eine Energiespeicher-Einrichtung (1.2.2) aufweist, die eingerichtet ist, die über den Energiewandler (1.1) aus der Primärenergie gewandelte elektrische Energie zu speichern, wobei die Energiespeicher-Einrichtung (1.2.2) einen ersten Energiespeicher (1.2.2.1) und einen zweiten Energiespeicher (1.2.2.2) umfasst, wobei der erste Energiespeicher (1.2.2.1) eine höhere Speicherkapazität hat als der zweite Energiespeicher (1.2.2.2) und wobei der zweite Energiespeicher (1.2.2.2) einen niedrigeren Innenwiderstand hat als der erste Energiespeicher (1.2.2.1), und wobei der erste Energiespeicher (1.2.2.1) und der zweite Energiespeicher (1.2.2.2) eingerichtet sind, die über den Energiewandler (1.1) aus der Primärenergie gewandelte elektrische Energie zu speichern.

6. Gerät nach einem der Ansprüche 1 bis 5, wobei der Energiewandler (1.1) eine Solarzelle umfasst und die Primärenergie Lichtenergie ist.

7. Gerät nach einem der Ansprüche 1 bis 6, wobei der Energiewandler (1.1) einen elektromechanischen Wandler, einen thermischen Wandler oder einen magnetischen Wandler oder eine Kombination davon umfasst.

8. Gerät nach einem der Ansprüche 1 bis 7, weiter aufweisend eine Lademanagement-Einrichtung (1.2.1) zum Lademanagement der Energiespeicher-Einrichtung (1.2.2), wobei die Lademanagement-Einrichtung (1.2.1) eingerichtet ist, eine Begrenzung der Ladespannung auf einen Maximalwert zu steuern und unterhalb einer vorgegebenen Mindestspannung der Energiespeicher-Einrichtung (1.2.2) einen Energieverbrauch des Gerätes zu steuern, einzuschränken oder abzustellen.

9. Gerät nach einem der Ansprüche 1 bis 8, wobei der erste Energiespeicher (1.2.2.1) und der zweite Energiespeicher (1.2.2.2) derart über eine oder mehrere Dioden verschaltet sind, dass elektrische Energie vom ersten Energiespeicher (1.2.2.1) in den zweiten Energiespeicher (1.2.2.2) übertragen werden kann, jedoch nicht vom zweiten Energiespeicher (1.2.2.2) in den ersten Energiespeicher (1.2.2.1).

10. Gerät nach einem der Ansprüche 1 bis 9, wobei der zweite Energiespeicher (1.2.2.2) derart verschaltet ist, dass elektrische Energie zum Betreiben des Geräts oder von einzelnen Komponenten des Gerätes aus dem zweiten Energiespeicher (1.2.2.2) entnehmbar ist und der zweite Energiespeicher (1.2.2.2) durch elektrische Energie aus dem ersten Energiespeicher (1.2.2.1) nachladbar ist.

11. Gerät nach einem der Ansprüche 1 bis 10, weiter aufweisend eine Energiespeicher-Hilfseinrichtung (1.2.3), die separat zur Energiespeicher-Einrichtung (1.2.2) eingerichtet ist zum Bereitstellen einer elektrischen Hilfsenergie zum Betreiben des Gerätes oder einzelner Komponenten des Gerätes.

12. Gerät nach einem der Ansprüche 1 bis 11, weiter aufweisend eine oder mehrere der folgenden Komponenten:
- einen Mikrokontroller (1.4.2),
- einen Daten-Speicher (1.4.3),
- ein Software-Programm (1.4.1) zum Steuern des Mikrocontrollers (1.4.2),
- einen Funk-Transmitter (1.6).

13. Gerät nach einem der Ansprüche 1 bis 12, weiter aufweisend eine Drahtlos-Schnittstelle (1.5), insbesondere eine Nahfeld-Kommunikations-Schnittstelle, zur drahtlosen Kommunikation und/oder Datenaustausch und/oder Energieübertragung mit anderen Geräten.

14. Verfahren zur Erfassung der Aktivität von Personen oder des Zustandes von durch Personen beeinflussten Infrastrukturen oder Gegenständen mittels Beschleunigungsmessung mit den Schritten:
- Messen einer Beschleunigung durch einen Beschleunigungssensor (1.3.1) eines Gerätes,
- Reagieren des Beschleunigungssensors (1.3.1) auf einen voreingestellten Schwellwert der gemessenen Beschleunigung,
- Auslösen zumindest einer der folgenden Aktionen durch den Beschleunigungssensor (1.3.1) bei Überschreitung des Schwellwertes:
- Datenspeicherung,
- Modifikation eines Zählers oder
- Aussendung eines Datentelegramms per Funk,
wobei das Gerät einen Energiewandler (1.1) aufweist, der eine Primärenergie in elektrische Energie zum Betreiben des Geräts oder des Beschleunigungssensors (1.3.1) wandelt, wobei der Beschleunigungssensor (1.3.1) über die aus der Primärenergie gewonnene elektrische Energie betrieben wird und der Energiewandler (1.1) die Primärenergie unabhängig von einer aus der gemessenen Beschleunigung resultierenden Energie gewinnt,
wobei das Gerät eine Energiespeicher-Einrichtung (1.2.2) aufweist, die die über den Energiewandler (1.1) aus der Primärenergie gewandelte elektrische Energie speichert, wobei die Energiespeicher-Einrichtung (1.2.2) einen ersten Energiespeicher (1.2.2.1) und einen zweiten Energiespeicher (1.2.2.2) umfasst, wobei der erste Energiespeicher (1.2.2.1) eine höhere Speicherkapazität hat als der zweite Energiespeicher (1.2.2.2) und wobei der zweite Energiespeicher (1.2.2.2) einen niedrigeren Innenwiderstand hat als der erste Energiespeicher (1.2.2.1), und wobei der erste Energiespeicher (1.2.2.1) und der zweite Energiespeicher (1.2.2.2) die über den Energiewandler (1.1) aus der Primärenergie gewandelte elektrische Energie speichern.

15. Verfahren zur Erfassung der Aktivität von Personen oder des Zustandes von durch Personen beeinflussten Infrastrukturen oder Gegenständen mittels Auswertung von mindestens zwei unterschiedlichen physikalischen Größen mit den Schritten:
- Messen von wenigstens zwei unterschiedlichen physikalischen Größen durch mindestens zwei verschiedene Sensoren (1.3.1, 1.3.2, 1.3.x) eines Gerätes,
- Reagieren eines oder mehrerer oder aller der mindestens zwei Sensoren (1.3.1, 1.3.2, 1.3.x) auf einen voreingestellten Schwellwert der jeweils gemessenen physikalischen Größe, und
- Auslösen zumindest einer der folgenden Aktionen durch mindestens einen reagierenden Sensor (1.3.1, 1.3.2, 1.3.x) bei Überschreitung des Schwellwertes:
- Datenspeicherung,
- Modifikation eines Zählers oder
- Aussendung eines Datentelegramms per Funk,
wobei das Gerät einen Energiewandler (1.1) aufweist, der eine Primärenergie in elektrische Energie zum Betreiben des Geräts oder der mindestens zwei Sensoren (1.3.1, 1.3.2, 1.3.x) wandelt, wobei einer oder mehrere oder alle der mindestens zwei Sensoren (1.3.1, 1.3.2, 1.3.x) über die aus der Primärenergie gewonnene elektrische Energie betrieben werden und der Energiewandler (1.1) die Primärenergie unabhängig von einer aus den jeweils gemessenen physikalischen Größen resultierenden Energie gewinnt,
wobei das Gerät eine Energiespeicher-Einrichtung (1.2.2) aufweist, die die über den Energiewandler (1.1) aus der Primärenergie gewandelte elektrische Energie speichern, wobei die Energiespeicher-Einrichtung (1.2.2) einen ersten Energiespeicher (1.2.2.1) und einen zweiten Energiespeicher (1.2.2.2) umfasst, wobei der erste Energiespeicher (1.2.2.1) eine höhere Speicherkapazität hat als der zweite Energiespeicher (1.2.2.2) und wobei der zweite Energiespeicher (1.2.2.2) einen niedrigeren Innenwiderstand hat als der erste Energiespeicher (1.2.2.1), und wobei der erste Energiespeicher (1.2.2.1) und der zweite Energiespeicher (1.2.2.2) die über den Energiewandler (1.1) aus der Primärenergie gewandelte elektrische Energie speichern.

## Claims

1. Device for detecting the activity of persons or the state of infrastructures or objects influenced by persons, by means of acceleration measurement,
- wherein the device has at least one acceleration sensor (1.3.1) for measuring an acceleration,
- wherein the acceleration sensor (1.3.1) is designed to react on a predefined threshold value of a measured acceleration, and to trigger at least one of the following actions when the threshold value is exceeded:
- data storage,
- modification of a counter, or
- sending a data telegram per radio, and
- wherein the device has an energy converter (1.1) for converting a primary energy into electric energy for operating the device or the acceleration sensor (1.3.1), wherein the energy converter (1.1) is designed to obtain the primary energy independently from an energy resulting from the measured acceleration,
- wherein the device has an energy storage facility (1.2.2) designed to store the electrical energy converted by the energy converter (1.1) from the primary energy, wherein the energy storage facility (1.2.) comprises a first energy storage facility (1.2.2.1) and a second energy storage facility (1.2.2.2), wherein the first energy storage facility (1.2.2.1) has a higher storage capacity than the second energy storage facility (1.2.2.2), and wherein the second energy storage facility (1.2.2.2) has a lower internal resistance than the first energy storage facility (1.2.2.1), and wherein the first energy storage facility (1.2.2.1) and the second energy storage facility (1.2.2.2) are designed to store the electrical energy converted by the energy coonverter (1.1) from the primary energy.

2. Device according to claim 1, wherein the acceleration sensor (1.3.1) is realized as an uniaxial or multi-axial acceleration sensor, in particular in MEMs design.

3. Device according to claim 1 or 2, wherein the acceleration sensor (1.3.1) is realized for detecting the acceleration of gaseous media, in particular as a microphone.

4. Device according to any one of claims 1 to 3, further including one or more of the following components:
- microphone, in particular for recording airborne sound,
- gas sensor, in particular for measuring CO2 and/or other air gases,
- temperature sensor,
- humidity sensor, in particular for measuring the humidity of ambient air,
- magnetic contact, Hall sensor, in particular for detecting the approximation of magnets,
- distance sensor, in particular ultrasound sensor, light sensor of inductively working sensor,
- tension sensor, in particular for measuring the energy state or energy level of the electric energy converted from the primary energy within the device,
- brightness sensor,
- key for manually operating the device.

5. Device for detecting the activity of persons or the state of infrastructures or objects influenced by persons,
- wherein the device has at least two sensors (1.3.1, 1.3.2, 1.3.x) designed for measuring different physical quantities,
- wherein one or more or all of the sensors (1.3.1, 1.3.2, 1.3.x) are designed to react on a predefined threshold value of the respectively measured physical quantity, and to to trigger at least of the following actions when the threshold value is exceeded:
- data storage,
- modification of a counter, or
- sending a data telegram per radio, and
- wherein the device has an energy converter (1.1) for converting a primary energy into electric energy for operating the device or one or more or all of the sensors (1.3.1, 1.3.2, 1.3.x), wherein the energy converter (1.1) is designed to obtain the primary energy independently from the energy resulting from the respectively measured physical quantity,
- wherein the device has an energy storage facility (1.2.2) designed to store electric energy converted by the energy converter (1.1) from the primary energy, wherein the energy storage facility (1.2.2) comprises a first energy storage facility (1.2.2.1) and a second energy storage facility (1.2.2.2), wherein the first energy storage facility (1.2.2.1) has a higher storage capacity than the second energy storage facility (1.2.2.2), and wherein the second energy storage facility (1.2.2.2) has a lower internal resistance than the first energy storage facility (1.2.2.1), and wherein the first energy storage facility (1.2.2.1) and the second energy storage facility (1.2.2.2) are designed to store electric energy converted by the energy converter (1.1) from primary energy energy.

6. Device according to any one of claims 1 to 5, wherein the energy converter (1.1) comprises a solar cell and the primary energy is light energy.

7. Device according to any one of claims 1 to 6, wherein the energy converter (1.1) includes an electromechanical converter, a thermal converter or a magnetic converter or a combination thereof.

8. Device according to any one of claims 1 to 7, further including a charge management facility (1.2.1) for the charge management of the energy storage facility (1.2.2), wherein the charge management facility (1.2.1) is designed to control the limitation of the charge voltage to a maximum value, and to control, to limit, or to turn off the energy consumption of the device below a predefined minimum tension of the energy storage facility (1.2.2).

9. Device according to any of of claims 1 to 8, wherein the first energy storage facility (1.2.2.1) and the second energy storage facility (1.2.2.2) are interconnected via one or more diodes in a manner that electric energy can be transmitted from the first energy storage facility (1.2.2.1) to the second energy storage facility (1.2.2.2), however not from the second energy storage facility (1.2.2.2) to the first energy storage facility (1.2.2.1).

10. Device according to any one of claims 1 to 9, wherein the second energy storage facility (1.2.2.2) is interconnected in a manner that electric energy for operating the device or of individual components of the device can be taken from the second energy storage facility (1.2.2.2), and the second energy storage facility (1.2.2.2) can be recharged by electric energy from the first energy storage facility (1.2.2.1).

11. Device according to any one of claims 1 to 10, further including an energy storage auxiliary facility (1.2.3) which is separately designed to the energy storage facility (1.2.2) and for providing electric auxiliary energy for operating the device or individual components of the device.

12. Device according to any one of claims 1 to 11, further including one or more of the following components:
- a microcontroller (1.4.2),
- a data storage (1.4.3),
- a software program (1.4.1) for controlling the microcontroller (1.4.2),
- a radio transmitter (1.6).

13. Device according to any one of claims 1 to 12, further including a wireless interface (1.5), in particular a near field communication interface for wireless communications and/or data exchange and/or energy transmittal to/from other devices.

14. Method for detecting the activity of persons or the state of infrastructures or objects influenced by persons, by means of acceleration measurement, including the steps of:
- measuring an acceleration by an acceleration sensor (1.3.1) of a device,
- reacting the acceleration sensor (1.3.1) to a predefined threshold value of the measured acceleration,
- triggering at least one of the following actions by the acceleration sensor (1.3.1), when the threshold value is exceeded :
- data storage
- modification of a counter, or
- sending of a data telegram per radio,
wherein the device comprises an energy converter (1.1) converting a primary energy into electric energy for operating the device or the acceleration sensor (1.3.1), wherein the acceleration sensor (1.3.1) is operated by the electric energy obtained from the primary energy, and the energy converter (1.1) obtains the primary energy independently from the energy resulting from the measured acceleration,
wherein the device comprises an energy storage facility (1.2.2) storing the electric energy converted by the energy converter (1.1) from the primary energy, wherein the energy storage facility (1.2.2) has a first energy storage facility (1.2.2.1) and a second energy storage (1.2.2.2), wherein the first energy storage facility (1.2.2.1) has a higher storage capacity than the second energy storage facility (1.2.2.2), and wherein the second energy storage facility (1.2.2.2) has a lower internal resistance than the first energy storage facility (1.2.2.1), and wherein the first energy storage facility (1.2.2.1) and the second energy storage (1.2.2.2) store the electric energy converted by the energy converter (1.1) from the primary energy.

15. Method for detecting the activity of persons or the state of infrastructures or objects influenced by persons, by means of evanulatin at least two different physical quantities comprising the steps of:
- measuring at least two different physical quantities by at least two different sensors (1.3.1, 1.3.2, 1.3.x) of a device,
- reacting one or more or all of the at least two sensors (1.3.1, 1.3.2. 1.3.x) to a predefined threshold value of the respectively measured physical quantity, and
- triggering at least one of the following actions by at least one reacting sensor (1.3.1, 1.3.2. 1.3.x), when the threshold value is exceeded:
- data storage
- modification of a counter, or
- sending a data telegram per radio,
wherein the device comprises an energy converter (1.1) converting a primary energy into electric energy for operating the device or the at least two sensors (1.3.1, 1.3.2, 1.3.x), wherein one or more or all of the at least two sensors (1.3.1, 1.3.2. 1.3.x) are operated by the electric energy obtained from the primary energy, and the energy converter (1.1) obtains the primary energy independently from the energy resulting from the respectively measured physical quantity,
wherein the device comprises an energy storage facility (1.2.2) storing the electric energy converted by the energy converter (1.1) from the primary energy, wherein the energy storage facility (1.2.2) comprises a first energy storage facility (1.2.2.1) and a second energy storage facility (1.2.2.2), wherein the first energy storage facility (1.2.2.1) has a higher storage capacity than the second energy storage facility (1.2.2.2), and wherein the second energy storage facility (1.2.2.2) has a lower internal resistance than the first energy storage facility (1.2.2.1), and wherein the first energy storage facility (1.2.2.1) and the second energy storage facility (1.2.2.2) store the electric energy converted by the energy converter (1.1) from the primary energy.

## Revendications

1. Appareil de détection de l'activité de personnes ou de l'état d'infrastructures ou d'objets sous l'influence de personnes par mesure d'accélération,
- sachant que l'appareil présente au moins un capteur d'accélération (1.3.1) destiné à mesurer une accélération,
- sachant que le capteur d'accélération (1.3.1) est configuré pour réagir à une valeur seuil préréglée d'une accélération mesurée et déclencher au moins une des actions suivantes en cas de dépassement de la valeur seuil :
- mémorisation de données,
- modification d'un compteur ou
- émission d'un télégramme de données par radio, et
- sachant que l'appareil présente un convertisseur d'énergie (1.1) pour la conversion d'une énergie primaire en énergie électrique pour l'exploitation de l'appareil ou du capteur d'accélération (1.3.1), sachant que le convertisseur d'énergie (1.1) est configuré pour obtenir l'énergie primaire indépendamment d'une énergie résultant d'une accélération mesurée,
- sachant que l'appareil présente un dispositif accumulateur d'énergie (1.2.2) qui est configuré pour accumuler l'énergie électrique convertie à partir de l'énergie primaire via le convertisseur d'énergie (1.1), sachant que le dispositif accumulateur d'énergie (1.2.2) comprend un premier accumulateur d'énergie (1.2.2.1) et un deuxième accumulateur d'énergie (1.2.2.2), sachant que le premier accumulateur d'énergie (1.2.2.1) a une capacité d'accumulateur plus élevée que le deuxième accumulateur d'énergie (1.2.2.2) et sachant que le deuxième accumulateur d'énergie (1.2.2.2) a une résistance interne plus basse que le premier accumulateur d'énergie (1.2.2.1), et sachant que le premier accumulateur d'énergie (1.2.2.1) et le deuxième accumulateur d'énergie (1.2.2.2) sont configurés pour accumuler l'énergie électrique convertie à partir de l'énergie primaire via le convertisseur d'énergie (1.1).

2. Appareil selon la revendication 1, sachant que le capteur d'accélération (1.3.1) est exécuté comme capteur d'accélération à un axe ou à plusieurs axes, en particulier en structure MEMS.

3. Appareil selon la revendication 1 ou 2, sachant que le capteur d'accélération (1.3.1) est exécuté pour la détection de l'accélération de fluides gazeux, en particulier comme microphone.

4. Appareil selon l'une des revendications 1 à 3, présentant en outre un ou plusieurs des composants suivants :
- microphone, en particulier pour la prise de son aérien,
- capteur de gaz, en particulier pour la mesure de CO2 et/ou d'autres gaz de l'air,
- capteur de température,
- capteur d'humidité, en particulier pour la mesure de l'humidité de l'air ambiant,
- contact magnétique, capteur de Hall, en particulier pour la saisie de l'approche d'aimants,
- capteur de distance, en particulier capteur ultrasonique, capteur lumineux ou capteur à fonctionnement inductif,
- capteur de tension, en particulier pour la mesure de l'état d'énergie ou du niveau d'énergie de l'énergie électrique convertie à partir de l'énergie primaire à l'intérieur de l'appareil,
- capteur de luminosité,
- bouton pour la commande manuelle de l'appareil.

5. Appareil pour la détection de l'activité de personnes ou de l'état d'infrastructures ou d'objets sous l'influence de personnes,
- sachant que l'appareil présente au moins deux capteurs (1.3.1, 1.3.2, 1.3.x) qui sont configurés pour la mesure de différentes grandeurs physiques,
- sachant qu'un ou plusieurs ou la totalité des capteurs (1.3.1, 1.3.2, 1.3.x) sont configurés pour réagir à une valeur seuil préréglée de la grandeur physique mesurée respectivement et déclencher au moins une des actions suivantes en cas de dépassement de la valeur seuil de la grandeur physique mesurée :
- mémorisation de données,
- modification d'un compteur ou
- émission d'un télégramme de données par radio, et
- sachant que l'appareil présente un convertisseur d'énergie (1.1) pour la conversion d'une énergie primaire en énergie électrique pour l'exploitation de l'appareil ou d'un ou de plusieurs ou de la totalité des capteurs (1.3.1, 1.3.2, 1.3.x), sachant que le convertisseur d'énergie (1.1) est configuré pour obtenir l'énergie primaire indépendamment d'une énergie résultant de la grandeur physique mesurée respectivement,
- sachant que l'appareil présente un dispositif accumulateur d'énergie (1.2.2) qui est configuré pour accumuler l'énergie électrique convertie à partir de l'énergie primaire via le convertisseur d'énergie (1.1), sachant que le dispositif accumulateur d'énergie (1.2.2) comprend un premier accumulateur d'énergie (1.2.2.1) et un deuxième accumulateur d'énergie (1.2.2.2), sachant que le premier accumulateur d'énergie (1.2.2.1) a une capacité d'accumulateur plus élevée que le deuxième accumulateur d'énergie (1.2.2.2) et sachant que le deuxième accumulateur d'énergie (1.2.2.2) a une résistance interne plus basse que le premier accumulateur d'énergie (1.2.2.1), et sachant que le premier accumulateur d'énergie (1.2.2.1) et le deuxième accumulateur d'énergie (1.2.2.2) sont configurés pour accumuler l'énergie électrique convertie à partir de l'énergie primaire via le convertisseur d'énergie (1.1).

6. Appareil selon l'une des revendications 1 à 5, sachant que le convertisseur d'énergie (1.1) comprend une cellule solaire et l'énergie primaire est de l'énergie lumineuse.

7. Appareil selon l'une des revendications 1 à 6, sachant que le convertisseur d'énergie (1.1) comprend un convertisseur électromécanique, un convertisseur thermique ou un convertisseur magnétique ou une combinaison de ceux-ci.

8. Appareil selon l'une des revendications 1 à 7, présentant en outre un dispositif de gestion de charge (1.2.1) pour la gestion de charge du dispositif accumulateur d'énergie (1.2.2), sachant que le dispositif de gestion de charge (1.2.1) est configuré pour commander une limitation de la tension de charge à une valeur maximale et commander, restreindre ou couper une consommation d'énergie de l'appareil en dessous d'une tension minimale spécifiée du dispositif accumulateur d'énergie (1.2.2).

9. Appareil selon l'une des revendications 1 à 8, sachant que le premier accumulateur d'énergie (1.2.2.1) et le deuxième accumulateur d'énergie (1.2.2.2) sont connectés via une ou plusieurs diodes de telle manière que de l'énergie électrique puisse être transmise du premier accumulateur d'énergie (1.2.2.1) au deuxième accumulateur d'énergie (1.2.2.2), mais pas du deuxième accumulateur d'énergie (1.2.2.2) au premier accumulateur d'énergie (1.2.2.1).

10. Appareil selon l'une des revendications 1 à 9, sachant que le deuxième accumulateur d'énergie (1.2.2.2) est connecté de telle manière que de l'énergie électrique puisse être soutirée du deuxième accumulateur d'énergie (1.2.2.2) pour l'exploitation de l'appareil ou de composants individuels de l'appareil et le deuxième accumulateur d'énergie (1.2.2.2) soit rechargeable par de l'énergie électrique provenant du premier accumulateur d'énergie (1.2.2.1).

11. Appareil selon l'une des revendications 1 à 10, présentant en outre un dispositif auxiliaire accumulateur d'énergie (1.2.3) qui est configuré séparément du dispositif accumulateur d'énergie (1.2.2) pour la mise à disposition d'une énergie auxiliaire électrique pour l'exploitation de l'appareil ou de composants individuels de l'appareil.

12. Appareil selon l'une des revendications 1 à 11, présentant en outre un ou plusieurs des composants suivants :
- un microcontrôleur (1.4.2),
- une mémoire de données (1.4.3),
- un programme logiciel (1.4.1) pour la commande du microcontrôleur (1.4.2),
- un transmetteur radio (1.6).

13. Appareil selon l'une des revendications 1 à 12, présentant en outre une interface sans fil (1.5), en particulier une interface de communication en champ proche, pour la communication et/ou l'échange de données et/ou la transmission d'énergie sans fil avec d'autres appareils.

14. Procédé de détection de l'activité de personnes ou de l'état d'infrastructures ou d'objets sous l'influence de personnes par mesure d'accélération, comprenant les étapes :
- mesure d'une accélération par un capteur d'accélération (1.3.1) d'un appareil,
- réaction du capteur d'accélération (1.3.1) à une valeur seuil préréglée de l'accélération mesurée,
- déclenchement d'au moins une des actions suivantes par le capteur d'accélération (1.3.1) en cas de dépassement de la valeur seuil :
o mémorisation de données,
o modification d'un compteur ou
o émission d'un télégramme de données par radio, sachant que l'appareil présente un convertisseur d'énergie (1.1) qui convertit une énergie primaire en énergie électrique pour l'exploitation de l'appareil ou du capteur d'accélération (1.3.1), sachant que le capteur d'accélération (1.3.1) est exploité via l'énergie électrique obtenue à partir de l'énergie primaire et le convertisseur d'énergie (1.1) obtient l'énergie primaire indépendamment d'une énergie résultant de l'accélération mesurée,
sachant que l'appareil présente un dispositif accumulateur d'énergie (1.2.2) qui accumule l'énergie électrique convertie à partir de l'énergie primaire via le convertisseur d'énergie (1.1), sachant que le dispositif accumulateur d'énergie (1.2.2) comprend un premier accumulateur d'énergie (1.2.2.1) et un deuxième accumulateur d'énergie (1.2.2.2), sachant que le premier accumulateur d'énergie (1.2.2.1) a une capacité d'accumulateur plus élevée que le deuxième accumulateur d'énergie (1.2.2.2) et sachant que le deuxième accumulateur d'énergie (1.2.2.2) a une résistance interne plus basse que le premier accumulateur d'énergie (1.2.2.1), et sachant que le premier accumulateur d'énergie (1.2.2.1) et le deuxième accumulateur d'énergie (1.2.2.2) accumulent l'énergie électrique convertie à partir de l'énergie primaire via le convertisseur d'énergie (1.1).

15. Procédé de détection de l'activité de personnes ou de l'état d'infrastructures ou d'objets sous l'influence de personnes par évaluation d'au moins deux grandeurs physiques différentes, comprenant les étapes :
- mesure d'au moins deux grandeurs physiques différentes par au moins deux capteurs (1.3.1, 1.3.2, 1.3.x) différents d'un appareil,
- réaction d'un ou de plusieurs ou de la totalité des au moins deux capteurs (1.3.1, 1.3.2, 1.3.x) à une valeur seuil préréglée de la grandeur physique mesurée respectivement, et
- déclenchement d'au moins une des actions suivantes par au moins un capteur (1.3.1, 1.3.2, 1.3.x) qui réagit en cas de dépassement de la valeur seuil :
- mémorisation de données,
- modification d'un compteur ou
- émission d'un télégramme de données par radio, sachant que l'appareil présente un convertisseur d'énergie (1.1) qui convertit une énergie primaire en énergie électrique pour l'exploitation de l'appareil ou des au moins deux capteurs (1.3.1. 1.3.2, 1.3.x), sachant qu'un ou plusieurs ou la totalité des au moins deux capteurs (1.3.1. 1.3.2, 1.3.x) sont exploités via l'énergie électrique obtenue à partir de l'énergie primaire et le convertisseur électrique (1.1) obtient l'énergie primaire indépendamment d'une énergie résultant des grandeurs physiques mesurées respectivement, sachant que l'appareil présente un dispositif accumulateur d'énergie (1.2.2) qui accumule l'énergie électrique convertie à partir de l'énergie primaire via le convertisseur d'énergie (1.1), sachant que le dispositif accumulateur d'énergie (1.2.2) comprend un premier accumulateur d'énergie (1.2.2.1) et un deuxième accumulateur d'énergie (1.2.2.2), sachant que le premier accumulateur d'énergie (1.2.2.1) a une capacité d'accumulateur plus élevée que le deuxième accumulateur d'énergie (1.2.2.2) et sachant que le deuxième accumulateur d'énergie (1.2.2.2) a une résistance interne plus basse que le premier accumulateur d'énergie (1.2.2.1), et sachant que le premier accumulateur d'énergie (1.2.2.1) et le deuxième accumulateur d'énergie (1.2.2.2) accumulent l'énergie électrique convertie à partir de l'énergie primaire via le convertisseur d'énergie (1.1).
